# EUROPÄISCHE PATENTSCHRIFT

(11) **EP 1 153 437 B1**
(45) Veröffentlichungstag und Bekanntmachung des Hinweises auf die Patenterteilung: **07.09.2005**
(21) Anmeldenummer: 99964430.5
(22) Anmeldetag: 08.12.1999
(51) Int. Cl.: H01L 29/737, H01L 21/331

(54) **BIPOLARTRANSISTOR UND VERFAHREN ZU SEINER HERSTELLUNG**
BIPOLAR TRANSISTOR AND METHOD FOR PRODUCING SAME
TRANSISTOR BIPOLAIRE ET SON PROCEDE DE PRODUCTION

(30) Priorität: 14.12.1998 DE 19857640
(43) Veröffentlichungstag der Anmeldung: 14.11.2001
(73) Patentinhaber: IHP GmbH-Innovations for High Performance Microelectronics/Institut für innovative Mikroelektronik, 15236 Frankfurt an der Oder (DE)
(72) Erfinder: HEINEMANN, Bernd, D-15234 Frankfurt (oder) (DE); EHWALD, Karl-Ernst, D-15234 Frankfurt (oder) (DE); KNOLL, Dieter, D-15230 Frankfurt (oder) (DE)
(74) Vertreter: Eisenführ, Speiser & Partner
(86) Internationale Anmeldenummer: PCT/DE1999/003961
(87) Internationale Veröffentlichungsnummer: WO 2000/036653

(56) Entgegenhaltungen:
- EP-A- 0 551 185
- EP-A- 0 795 899
- WO-A-98/26457
- DE-A- 4 102 888
- COMFORT J H ET AL: "SINGLE CRYSTAL EMITTER CAP FOR EPITAXIAL SI- AND SIGE-BASE TRANSISTORS" PROCEEDINGS OF THE INTERNATIONAL ELECTRON DEVICES MEETING,US,NEW YORK, IEEE, Bd. -, 1991, Seiten 91-857-91-860, XP000347370 ISBN: 0-7803-0243-5
- GRUHLE A ET AL: "LOW 1/NOISE SIGE HBTS WITH APPLICATION TO LOW PHASE NOISE MICROWAVE OSCILLATORS" ELECTRONICS LETTERS,GB,IEE STEVENAGE, Bd. 33, Nr. 24, 1997, Seiten 2050-2052, XP000884013 ISSN: 0013-5194 in der Anmeldung erwähnt
- CHANTRE A ET AL: "A HIGH PERFORMANCE LOW COMPLEXITY SIGE HBT FOR BICMOS INTEGRATION" IEEE BIPOLAR/BICMOS CIRCUITS AND TECHNOLOGY MEETING,US,NEW YORK, NY: IEEE, 1998, Seiten 93-96, XP000877001 ISBN: 0-7803-4498-7 in der Anmeldung erwähnt

## Beschreibung

Die Erfindung betrifft einen Bipolartransistor und ein Verfahren zu seiner Herstellung.

Die Realisierung von epitaktisch hergestellten Silizium-Germanium-Heterobipolartransistoren (SiGe-HBT) sowie die kostensparende Vereinfachung der technologischen Prozesse gaben in jüngerer Zeit neue Impulse für die Weiterentwicklung von Si-Bipolartransistoren. Einen attraktiven Weg eröffnet in dieser Hinsicht die Verbindung einer epitaktisch erzeugten Basis mit den prozeßvereinfachenden Möglichkeiten einer Einzel-Polysilizium-Technologie.

Im Vergleich zu konventionell per Implantation oder Eindiffusion eingebrachten Basisprofilen können mit Hilfe epitaktisch hergestellter Silizium-Germanium-Basisschichten gleichzeitig kleinere Basisweiten und -schichtwiderstände erzeugt werden, ohne daß unbrauchbar kleine Stromverstärkungen oder hohe Leckströme in Kauf genommen werden müssen. Dabei sind elektrisch aktive Dotierstoffkonzentrationen in der Basis bis über 1^{.}10²⁰ cm⁻³ realisiert worden, wie beispielsweise in A. Schüppen, A. Gruhle, U. Erben, H. Kibbel und U. König: 90 GHz fmax SiGe-HBTs, DRC 94, S. IIA-2, 1994 beschrieben. Um Leckströme durch Tunnelprozesse zu vermeiden, ist jedoch eine niedrig dotierte Zone zwischen den Hochkonzentrationsgebieten von Emitter und Basis nötig. Übersteigt nämlich die Basisdotierung Werte von 5^{.}10¹⁸ cm⁻³, und würde, wie bei implantierten Basisprofilen üblich, die Hochkonzentration des Emitters bis in die Basis hineinreichen, sind unakzeptabel hohe Tunnelströme die Folge. Im Unterschied zu implantierten Basisprofilen ist es bei Anwendung der Epitaxie problemlos möglich, gleichzeitig schmale Basisprofile sowie eine niedrig dotierte Zone (Cap-Schicht) zu erzeugen.

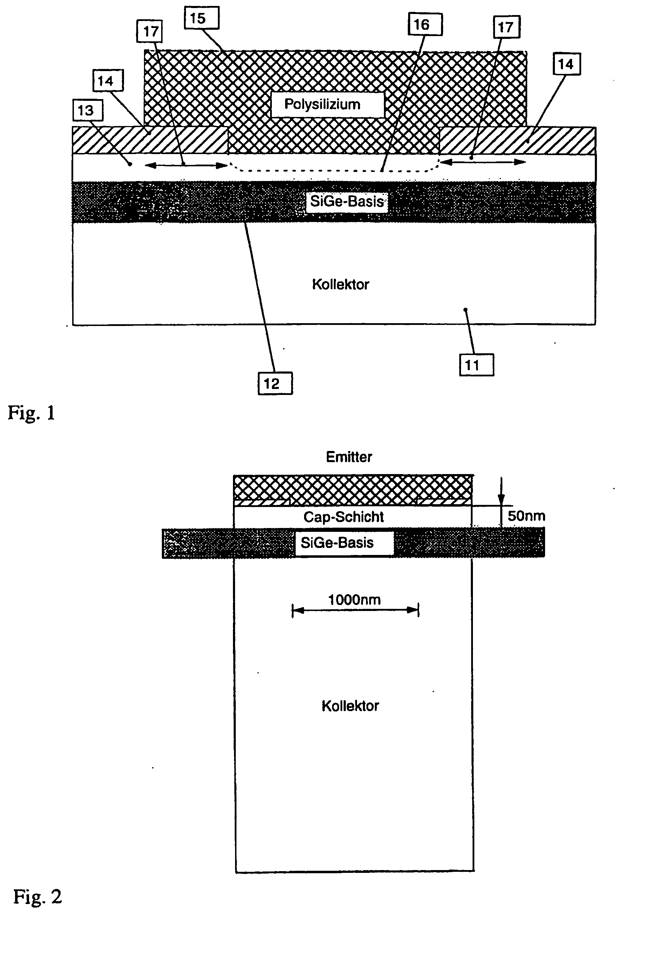

Fig. 1 zeigt schematisch den Emitterbereich eines SiGe-HBTs. Der Transistoraufbau gibt typische Merkmale eines Einzel-Polysiliziumprozesses wieder. Über einkristallinem Kollektorgebiet **11** wurde epitaktisch eine SiGe-Basis **12** und anschließend die Cap-Schicht **13** abgeschieden. Eine seitliche Isolation des Transistorgebietes ist in Fig. 1 nicht mit eingezeichnet. Wenn während des Epitaxieschrittes sowohl auf einkristallinem Substrat **11** als auch auf dem nicht dargestellten Isolatorgebiet Halbleitermaterial wächst (differentielle Epitaxie), ist es möglich, die gewachsenen Halbleiterschichten als Verbindung zwischen einem Kontakt auf Isolationsgebiet und dem inneren Transistor zu nutzen. Diese Verbindung sollte möglichst niederohmig ausgelegt sein. Daher wäre es günstig, wenn die Epitaxieschichtdicke unabhängig von der Basisweite eingestellt werden könnte. Über der Isolationsschicht **14,** in die naßchemisch Emitterfenster geätzt wurden, ist eine Poly- oder α-Siliziumschicht **15** abgeschieden worden. Die α-Siliziumschicht **15** erhält während der Abscheidung oder nachträglich per Implantation eine Dotierung vom Leitfähigkeitstyp des Emitters und dient als Diffusionsquelle für die Emitterdotierung **16** im einkristallinen Substrat. Die Isolatorschicht **14** wird eingesetzt, um keine Schädigung der Cap-Schicht **13** bei der später erfolgten Strukturierung der polykristallinen α-Siliziumschicht **15** hinnehmen zu müssen. Im Überlappungsbereich **17** des Polysiliziums, dem Gebiet zwischen dem Rand des Emitterfensters und der äußeren Begrenzung der strukturierten Poly- oder α-Siliziumschicht **15,** entsteht eine Schichtfolge, bestehend aus Halbleiter-, Isolator- und Halbleitermaterial. In Abhängigkeit von der Dotierung der Cap-Schicht **13,** von Grenzflächenladungen und Rekombinationseigenschaften der Oberfläche sowie den Betriebsbedingungen des Transistors kann dieser Aufbau analog zu einer MOS-Kapazität eine Anreicherung aber auch Verarmung an beweglichen Ladungsträgern an der Oberfläche der Cap-Schicht **13** bewirken.

Bei flußgepolter Basis-Emitter-Diode können dadurch sowohl die Idealität des Basisstroms als auch die Niederfrequenz-Rauscheigenschaften beeinträchtigt werden. In Sperrichtung werden Generationsströme und Durchbruchsspannungen unter Umständen negativ beeinflußt.

Unter der Bedingung, daß wegen der Tunnelgefahr die Dotandenkonzentrationen in der Cap-Schicht das Niveau von 5^{.}10¹⁸ cm⁻³ nicht übersteigen sollten, erhebt sich die Frage, in welcher Weise diese Zone geeignet zu dotieren ist. Im folgenden werden die bisher bekannten Varianten für npn-SiGe-HBTs diskutiert: Homogene n- oder p-Dotieremgen nahe der Tunnelgrenze bzw. quasi undotierte Gebiete (i-Zone). In A. Chantre, M. Marty, J. L. Regolini, M. Mouis, J. de Pontcharra, D. Dutartre, C. Morin, D. Gloria, S. Jouan, R. Pantel, M. Laurens, and A. Monroy: A high performance low complexity SiGe HBT for BiCMOS integration, BCTM '98, S. 93 - 96, 1998 wird eine p-Dotierung von ca. 5^{.}10¹⁸ cm⁻³ verwendet. Hieraus resultiert der entscheidende Nachteil, daß die Cap-Schichtdicke in einem Toleranzbereich von wenigen Nanometern an die Eindringtiefe des aus der Poly-Silizium-Emitter-Schicht ausdiffundierenden Dotierstoffes angepaßt sein muß. Größere Cap-Schichtdicken, die für eine niederohmige Verbindung der inneren Basis zu einem Anschluß auf Isolationsgebiet vorteilhaft wären, verbieten sich, da sonst die Wirkung des Germanium-Profils stark eingeschränkt wird. In A. Gruhle, C. Mähner: Low 1/f noise SiGe HBTs with application to low phase noise microwave oscillators, Electronics Letters, Vol. 33, No. 24, S. 2050 - 2052, 1997, wird eine 100 nm dicke Cap-Schicht mit einer n-Konzentration von 1-2^{.}10¹⁸ cm⁻³ verwendet. Ähnliche Bedingungen werden in der **EP-A-0 795 899** angegeben, wobei vorzugsweise eine Cap-Schicht-Dicke von 70 nm mit einer n-Dotierkonzentration von 2^{.}10¹⁸ cm⁻³ eingesetzt wird. Obgleich bei dieser Variante das Problem der Dickentoleranz der Cap-Schicht behoben und die Gefahr von Tunnelströmen durch die Verringerung der Dotierstoffkonzentration in der Cap-Schicht beseitigt ist, sind auch hier die Möglichkeiten zur Reduktion der Basis-Emitter-Kapazität nicht optimal ausgeschöpft.

Dieser Nachteil läßt sich umgehen, wenn auf eine Cap-Dotierung weitgehend verzichtet wird, wie beispielsweise in B. Heinemann, F. Herzel und U. Zillmann: Influence of low doped emitter and collector regions on high-frequency performance of SiGe-base HBTs, Solid-St. Electron., Bd. 38(6), S. 1183 - 1189, 1995 beschrieben. Allerdings kann es dann leicht zu der oben beschriebenen Verarmung des Überlappungsgebietes 17 kommen. Diese Zusammen-hänge werden im folgenden mit Hilfe zweidimensionaler Bauelementesimulation erläutert.

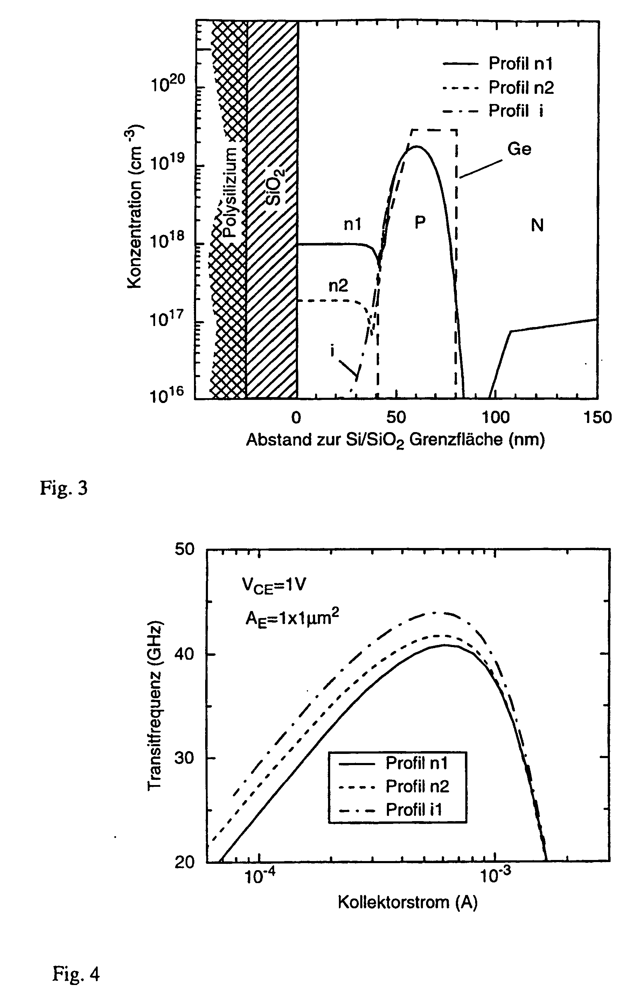

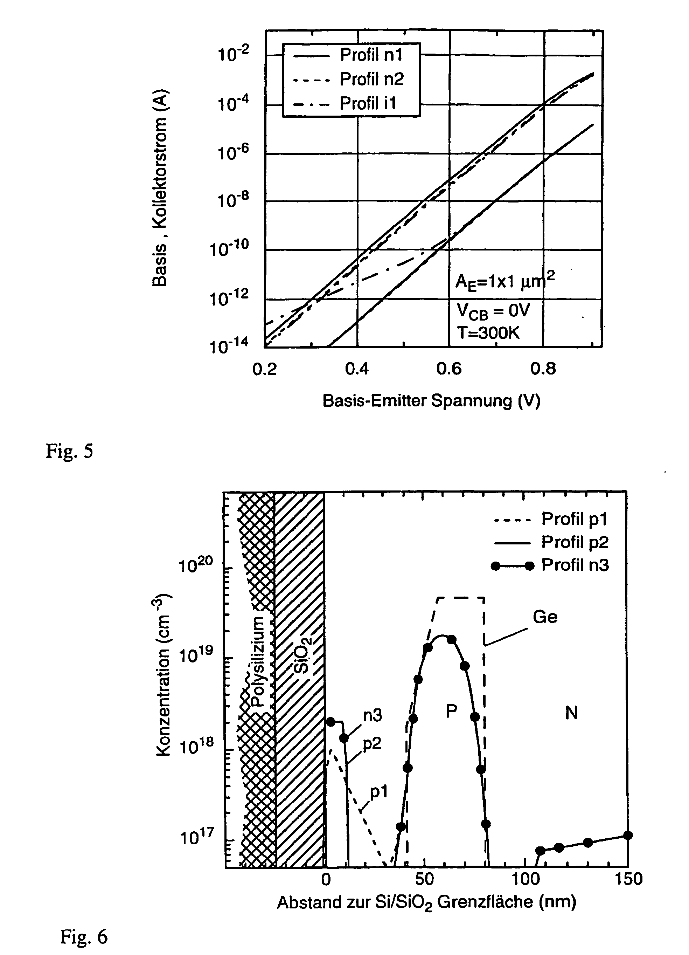

Fig. 2 zeigt den in der Simulation verwendeten, vereinfachten Transitorautbau. Die elektrische Wirkung der Oxid-Halbleitergrenzfläche im Überlappungsgebiet wird mit einer positiven Flächenladungsdichte von 1^{.}10¹¹ cm⁻² sowie einer Oberflächenrekombinations-geschwindigkeit von 1000 cm/s modelliert. In Fig. 3 sind Vertikalprofile entlang einer Schnittlinie senkrecht zum Überlappungsbereich dargestellt. Die Profile zeigen drei Dotierungsvarianten in der Cap-Schicht **13** und die in allen Fällen identisch vorgegebene, p-dotierte SiGe-Basis **12.** Es werden folgende Cap-Dotierungen verglichen: quasi undotierte Cap-Schicht **13** (Profil i) und zwei homogene n-Dotierungen (Profil n1 mit 1^{.}10¹⁸ cm⁻³ und Profil n2 mit 2^{.}10¹⁷ cm⁻³). Fig. 4 zeigt die Transitfrequenz als Funktion des Kollektorstromes für die verschiedenen Cap-Dotierungen. Insbesondere bei kleinen Kollektorströmen ist eine Zunahme der Transitfrequenz mit sinkendem Dotierungsniveau in der Cap-Schicht **13** zu erkennen. Während das Profil i vergleichsweise die besten Transitfrequenzen liefert, stellt sich als Nachteil jedoch heraus, daß sich die Idealität des Basisstromes (Fig. 5) im Gummel-Plot gegenüber den Vergleichsprofilen spürbar verschlechtert hat.

Aufgabe der Erfindung ist es, einen Bipolartransistor und ein Verfahren zu seiner Herstellung anzugeben, bei dem die beschriebenen Nachteile konventioneller Anordnungen überwunden werden, um insbesondere minimale Basis-Emitter-Kapazitäten und beste Hochfrequenzeigenschaften zu realisieren, ohne daß die statischen Eigenschaften eines Bipolartransistors mit schwach dotierter Cap-Schicht, vor allem die Basisstromidealität und das Niederfrequenz-Rauschen, spürbar verschlechtert werden und die Prozeßkomplexität zunimmt.

Erfindungsgemäß wird diese Aufgabe durch die Einbringung eines speziellen Dotierungsprofils in eine epitaktisch erzeugte Cap-Schicht (Cap-Dotierung) gelöst. Mit Hilfe dieses Dotierungsprofils wird erreicht, daß eine minimale Basis-Emitter-Kapazität und beste Hochfrequenzeigenschaften erreicht werden können, aber auch die generations-/rekombinationsaktive Grenzfläche zwischen Cap-Schicht und Isolator im Polysilizium-Überlappungsgebiet im interessanten Arbeitsbereich des Transistors in ihrer Wirksamkeit eingeschränkt und die Basisstromidealität verbessert wird.

Entscheidend für die guten Hochfrequenzeigenschaften ist der nur schwach, vorzugsweise kleiner als 5^{.}10¹⁶ cm⁻³ dotierte basisseitige Abschnitt in der Cap-Schicht mit einer bevorzugten Dicke zwischen 20 nm und 70 nm.

Emitterseitig ist die Cap-Schicht höher dotiert. Wenn der Dotierstoff den Leitfähigkeitstyp der Basisschicht besitzt, werden zur Vermeidung von Tunnelströmen Dotierstoffkonzentrationen in der Cap-Schicht von vorzugsweise kleiner als 5^{.}10¹⁸ cm⁻³ eingesetzt.

Vorzugsweise wird das Cap-Dotierungsprofil mittels Implantation oder in situ während des Epitaxieschrittes eingebracht.

Die Merkmale der Erfindung gehen außer aus den Ansprüchen auch aus der Beschreibung und den Zeichnungen hervor, wobei die einzelnen Merkmale jeweils für sich allein oder zu mehreren in Form von Unterkombinationen schutzfähige Ausführungen darstellen, für die hier Schutz beansprucht wird. Ausführungsbeispiele der Erfindung sind in den Zeichnungen dargestellt und werden im folgenden näher erläutert.

Die Zeichnungen zeigen:
- Fig. 1: Schematische Darstellung des Emittergebietes eines Bipolartransistors, hergestellt in einer Einzel-Polysilizium-Technologie mit epitaktisch abgeschiedener Basis,
- Fig. 2: Schematische Darstellung des Simulationsgebietes für den Bipolartransistor nach Fig. 1 (nicht maßstabsgerecht),
- Fig. 3: Vertikale Dotierungsprofile unter dem Überlappungsbereich für verschiedene Cap-Dotierungen,
- Fig. 4: Transit-Frequenz als Funktion der Kollektorstromdichte für unterschiedliche Dotierungsprofile,
- Fig. 5: Gummel-Plots für verschiedene Dotierungsprofile,
- Fig. 6: Vertikale Dotierungsprofile unter dem Überlappungsbereich für verschiedene Cap-Dotierungen,
- Fig. 7: Gummel-Plots für verschiedene Dotierungsprofile,
- Fig. 8: Transit-Frequenz als Funktion der Kollektorstromdichte für unterschiedliche Dotierungsprofile und
- Fig. 9: Schematische Darstellung eines Bipolartransistors während der Herstellung.

Die Merkmale und Wirkungsweise der erfindungsgemäßen Cap-Dotierungsprofile werden mit Hilfe zweidimensionaler Bauelementesimulation an einem npn SiGe-HBT beschrieben. Die Darlegungen lassen sich in entsprechender Weise auf einen pnp-Transistor übertragen.

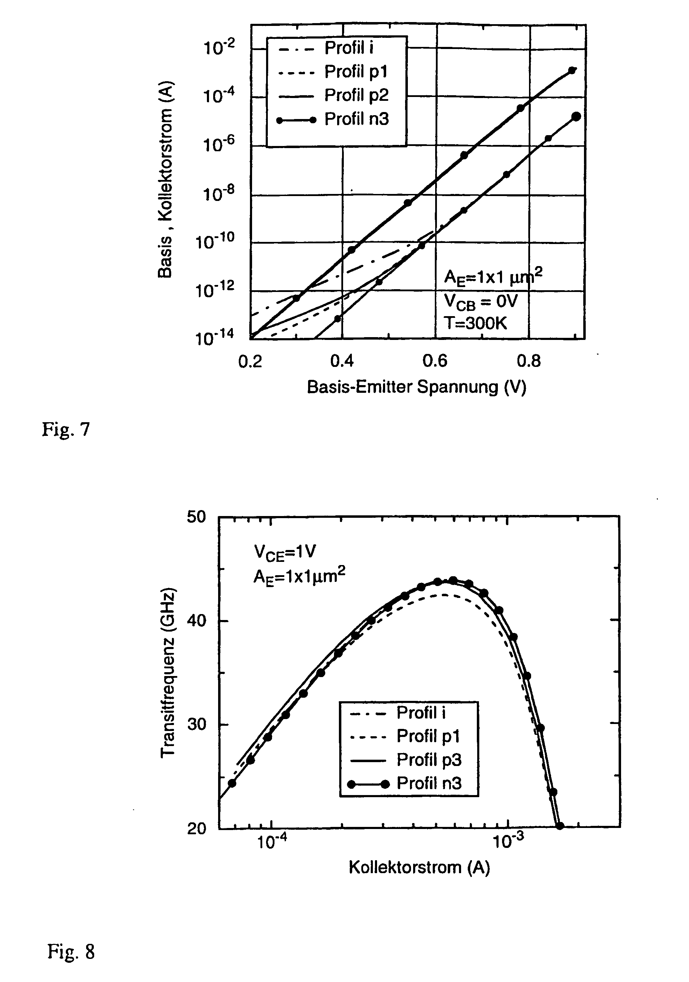

Fig. 6 zeigt charakteristische Beispiele für die hier vorgeschlagenen Vertikalprofile in der Cap-Schicht **13** entlang einer Schnittlinie senkrecht zum Überlappungsbereich. Das Cap- "Profil p1" ist zur Cap-Schicht-Oberfläche hin ansteigend und erreicht dort mit ca. 9^{.}10¹⁷ cm⁻³ seine maximale Konzentration, während die 10 nm breiten, kastenähnlichen Profile "p2 und n3" mit 2^{.}10¹⁸ cm⁻³ dotiert sind. Die Profile p1 und p2 sind vom p-Leitfähigkeitstyp, n3 vom n-Typ. In Fig. 7 sind Gummel-Plots zu den Profilen p1, p2 und n3 dargestellt, wobei zum Vergleich die Kennlinien vom Profil i aus Fig. 5 übernommen wurden. Fig. 7 zeigt deutlich die Verbesserung der Idealität der Basisstromkennlinien bei Verwendung der Cap-Dotierung gegenüber dem Verhalten von Profil i. Die dynamischen Berechnungen zu diesen Profilen führen zu dem in Fig. 8 wiedergegebenen Ergebnis: Im Unterschied zu den homogenen Dotierungen n1 und n2 mit Konzentrationen von 1^{.}10¹⁸ cm⁻³ und 2^{.}10¹⁷ cm⁻³ ist für die Cap-Profile p1, p2 und n3 keine Verschlechterung der Transitfrequenzen im Vergleich zu Profil i zu erkennen. Entscheidend für die guten Hochfrequenzeigenschaften ist der nur schwach, vorzugsweise kleiner als 5^{.}10¹⁶ cm⁻³ dotierte Abschnitt in der Cap-Schicht mit einer bevorzugten Dicke von mindestens 20 nm. Die Resultate weisen darauf hin, daß im hier betrachteten Beispiel sowohl mit n- als auch mit p-Profil in der Cap-Schicht annähernd gleichwertige Ergebnisse erreichbar sind.

Welcher Dotierungstyp in der Praxis zu bevorzugen ist, hängt z. B. davon ab, welchen Typ und welche Dichte die Ladungen an der Si/Isolator-Grenzfläche oder im Isolator besitzen oder welche Herstellungsverfahren für die Cap-Dotierung in Frage kommen. So lassen sich die vorgeschlagenen Profile z. B. per Implantation einbringen. Diese Variante ist jedoch nur dann zu bevorzugen, wenn die Auswirkungen von Punktdefekten auf das Basisprofil kontrollierbar sind. Würde es infolge der Ausheilung von Punktdefekten zu einer verstärkten Diffusion der Basisdotierung aus der SiGe-Schicht kommen und hierdurch die elektrischen Eigenschaften unakzeptabel verschlechtert werden, sind andere Dotierungsvarianten nötig. Zum Beispiel bietet sich eine in situ Dotierung während der Epitaxie an. Bei diesem Vorgehen wird der Typ der Cap-Dotierung mitbestimmt von der Sicherheit und Einfachheit des Abscheideprozesses.

Im folgenden wird die Herstellung eines Bipolartransistors gemäß der Erfindung am Beispiel eines npn SiGe-HBTs dargelegt. Die dabei vorgestellte Verfahrensweise kann ebensogut auf pnp-Transistoren übertragen werden. Außerdem ist es erfindungsgemäß auch möglich, auf eine Epitaxie der Basisschicht zu verzichten und das Basisprofil vor der epitaktischen Herstellung einer Cap-Schicht per Implantation einzubringen.

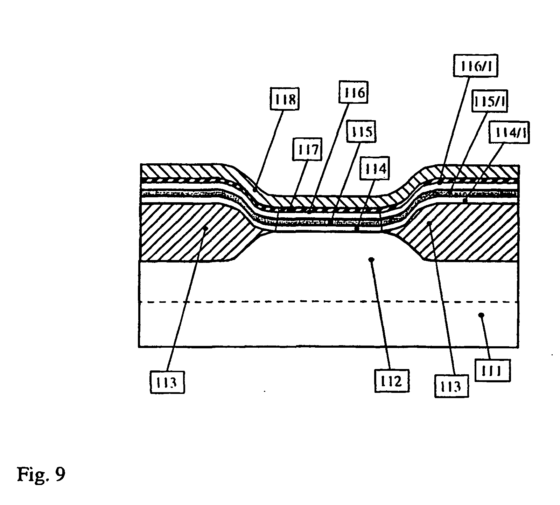

Wie in Fig. 9 dargestellt, wurden auf einer einkristallinen Substratschicht **111** vom Leitfähigkeitstyp I strukturierte Gebiete, bestehend aus einem Kollektorbereich **112** vom Leitfähigkeitstyp II, sowie diesen umgebende Isolationsgebiete **113** erzeugt. Sind Emitter und Kollektor z.B. n-leitend, ist die Basis vom p-Typ bzw. umgekehrt.

Es sind verschiedene geeignete Isolationstechniken bekannt, wie z.B. LOCOS-Prozesse, verspacerte Mesa-Anordnungen bzw. tiefe oder flache Trenchisolationen.

Auf der Basis differentieller Epitaxie wird ganzflächig die Pufferschicht **114,** die SiGe-Schicht mit in-situ Dotierung der Basisschicht **115** vom Leitfähigkeitstyp I sowie die Cap-Schicht **116** erzeugt.

Während die Pufferschicht **114,** die Basisschicht **115** und Cap-Schicht **116** einkristallin über dem Silizium-Substrat wachsen, entstehen polykristalline Schichten **114/1;115/1;116/1** über dem Isolationsgebiet **113.** Nach photolithografischer Maskierung werden Trockenätztechniken eingesetzt, um die Epitaxieschicht in denjenigen Gebieten zu entfernen, in denen keine Transistoren entstehen.

Verwendet man anstelle differentieller eine selektive Epitaxie, bei der ein Wachstum ausschließlich über Siliziumuntergrund erfolgt, entfällt im Unterschied zum Prozeßablauf mit differentieller Epitaxie die Strukturierung des Epitaxiestapels.

Im folgenden Schritt werden die Siliziumgebiete mit einer Isolationsschicht **117** abgedeckt. Es ist möglich, dies durch thermische Oxidation und/oder Abscheidung zu erreichen. Es können Schichtstapel von Dielektrika, z. B. Siliziumoxid und -nitrid, eingesetzt werden. Außerdem kann die elektrisch isolierende Schicht mit einer Polysiliziumschicht bedeckt sein, um zusätzliche Freiheitsgrade für den späteren Prozeßablauf offenzuhalten.

Als wesentlich im Sinne des erfindungsgemäßen Verfahrens ist die Realisierung des Cap-Dotierungsprofils in einer epitaktisch hergestellten Cap-Schicht anzusehen. Es besteht die Möglichkeit, ähnliche Profile wie die in Fig. 6 gezeigten, in situ während der Epitaxie einzubringen. Des weiteren kann durch Implantation vor oder nach Herstellung der Isolationsschicht **117** ein flaches Profil erzeugt werden. Außerdem sind verschiedene Verfahren zur Eindiffusion derartiger Profile bekannt. Dafür kann auch eine mit Dotierstoff hochangereicherte Isolatorschicht dienen. Ein Ausdiffusionsschritt kann vor oder nach weiteren Prozeßschritten erfolgen. Insbesondere bei Anwendung solcher Prozeßschritte wie Implantation, Eindiffusion oder thermischer Oxidation, die eine beschleunigte Diffusion der Dotanden hervorrufen können, ist der Einsatz eines diffusionshemmenden Zusatzstoffes in Kollektor, Basis oder Cap-Schicht **116,** wie z. B. Kohlenstoff, sinnvoll.

Die Transistorherstellung kann nun fortgesetzt werden mit der Strukturierung einer Lackmaske zur Öffnung des Emitterfensters. Dort werden die Deckschichten mit Hilfe bekannter Ätzverfahren abgetragen. Um gute Transistoreigenschaften zu erzielen, sind vorzugsweise Naßätztechniken beim Freilegen der Halbleiteroberfläche anzuwenden.

Der Prozeß wird fortgesetzt mit der Abscheidung einer amorphen Siliziumschicht für die Bildung des Polysiliziumemitters. Diese kann bereits in-situ während oder im Anschluß an die Abscheidung durch Implantation dotiert werden.

Der Prozeß wird mit konventionellen Schritten der Strukturierung, Implantation und Passivierung fortgesetzt. Zur Ausheilung der Implantationsschäden und zur Formierung des Poly-Emitters werden erforderliche Hoch-Temperaturschritte durchgeführt. Der Prozeß wird vervollständigt mit dem Öffnen der Kontaktlöcher für Emitter, Basis und Kollektor und einer Standardmetallisierung für die Transistorkontakte.

In der vorliegenden Erfindung wurden anhand konkreter Ausführungsbeispiele ein Bipolartransistor und ein Verfahren zu seiner Herstellung erläutert. Es sei aber vermerkt, daß die vorliegende Erfindung nicht auf die Einzelheiten der Beschreibung im Ausführungsbeispiel eingeschränkt ist, da im Rahmen der Patentansprüche Änderungen und Abwandlungen beansprucht werden.

## Patentansprüche

1. Verfahren zur Herstellung eines Bipolartransistors, bei dem auf einer einkristallinen Substratschicht **(111)** strukturierte Gebiete, bestehend aus einem Kollektorbereich **(112),** sowie diesen umgebende Isolationsgebiete **(113)** erzeugt werden, über dem Kollektorbereich **(112)** eine Basisschicht **(115),** wobei eine dazwischenliegende Pufferschicht **(114)** abgeschieden werden kann, und mittels Epitaxie eine Cap-Schicht **(116)** hergestellt werden, über der Cap-Schicht **(116)** eine Isolationsschicht **(117)** abgeschieden und diese im Bereich des wirksamen Emittergebietes geöffnet wird, über der geöffneten Isolationsschicht **(117)** eine Poly- oder α-Si-Schicht abgeschieden, strukturiert und als Emitter-Dotierstoffquelle und Kontaktschicht genutzt wird, ein Dotierungsprofil in die Cap-Schicht **(116)** eingebracht wird, welches basisseitig schwach und emitterseitig höher dotiert ist, **dadurch gekennzeichnet, daß** besagtes Dotierungsprofil in die Cap-Schicht **(116)** vor dem Eindiffusionsschritt aus der Emitterdotierstoffquelle eingebracht wird, so, daß im Überlappungsbereich, dem Gebiet zwischen dem Rand des Emitterfensters und der äußeren Begrenzung der strukturierten Poly- oder α-Si Schicht, die Cap-Schicht besagtes Dotierungsprofil enthält.

2. Verfahren nach Anspruch 1, **dadurch gekennzeichnet, daß** die basisseitig schwächere Dotierstoffkonzentration der Cap-Schicht **(116)** Werte von 5^{.}10¹⁶ cm⁻³ nicht übersteigt.

3. Verfahren nach Anspruch 1 oder 2, **dadurch gekennzeichnet, daß** die basisseitig schwächere Dotierstoffkonzentration der Cap-Schicht **(116)** eine Schichtdicke zwischen 20 nm und 70 nm besitzt.

4. Verfahren nach einem oder mehreren der vorhergehenden Ansprüche, **dadurch gekennzeichnet, daß** die emitterseitig höhere Dotierstoffkonzentration der Cap-Schicht (116) Werte von 5^{.}10¹⁸ cm⁻³ nicht übersteigt, wenn der Dotierstoff den Leitfähigkeitstyp der Basisschicht (115) besitzt.

5. Verfahren nach einem oder mehreren der vorhergehenden Ansprüche, **dadurch gekennzeichnet, daß** das Cap-Dotierungsprofil mittels Implantation eingebracht wird.

6. Verfahren nach einem oder mehreren der vorhergehenden Ansprüche, **dadurch gekennzeichnet, daß** das Cap-Dotierungsprofil in situ während des Epitaxieschrittes eingebracht wird.

7. Verfahren nach einem oder mehreren der vorhergehenden Ansprüche, **dadurch gekennzeichnet, daß** das Cap-Dotierungsprofil durch Ausdiffusion aus der mit Dotierstoff hochangereicherten Isolationsschicht **(117)** erzeugt wird.

8. Bipolartransistor, bei dem auf einer einkristallinen Substratschicht **(111)** strukturierte Gebiete, bestehend aus einem Kollektorbereich **(112),** sowie diesen umgebende Isolationsgebiete **(113)** erzeugt sind, über dem Kollektorbereich **(112)** eine Basisschicht **(115),** wobei eine Pufferschicht **(114)** dazwischen liegen kann, und mittels Epitaxie eine Cap-Schicht **(116)** hergestellt ist, über der Cap-Schicht **(116)** eine Isolationsschicht **(117)** abgeschieden und diese im Bereich des wirksamen Emittergebietes geöffnet ist, über der geöffneten Isolationsschicht **(117)** eine Poly- oder α-Si-Schicht abgeschiden und strukturiert ist, und als Emitter-Dotierstoffquelle und Kontaktschicht genutzt wird, **dadurch gekennzeichnet, daß** im Überlappungsbereich **(17),** dem Gebiet zwischen dem Rand des Emitterfensters und der äußeren Begrenzung der strukturierten Poly- oder α-Siliziumschicht **(15),** die Cap-Schicht **(13/116)** ein Dotierungsprofil enthält, welches basisseitig schwach und emitterseitig höher dotiert ist.

9. Bipolartransistor nach Anspruch 8, **dadurch gekennzeichnet, daß** die basisseitig schwächere Dotierstoffkonzentration der Cap-Schicht **(13/116)** Werte von 5^{.}10¹⁶ cm⁻³ nicht übersteigt.

10. Bipolartransistor nach einem oder mehreren der Anspruch 8 bis 9, **dadurch gekennzeichnet, daß** die basisseitig schwächere Dotierstoffkonzentration der Cap-Schicht **(13/116)** eine Schichtdicke zwischen 20 nm und 70 nm besitzt.

11. Bipolartransistor nach einem oder mehreren der Ansprüche 8 bis 10, **dadurch gekennzeichnet, daß** die emitterseitig höhere Dotierstoffkonzentration der Cap-Schicht **(13/116)** Werte von 5^{.}10¹⁸ cm⁻³ nicht übersteigt, wenn der Dotierstoff den Leitfähigkeitstyp der Basisschicht **(12,115)** besitzt.

## Claims

1. Method for producing a bipolar transistor, in which structured regions, consisting of a collector region (112) and insulation regions (113) surrounding the latter are produced on a monocrystal substrate layer (111), over the collector region (112) a base layer (115), whereby an intermediate buffer layer (114) can be deposited and by means of epitaxy a cap layer (116) can be produced, an insulation layer (117) deposited over the cap layer (116) and said insulation layer is opened in an area of the effective emitter zone, and a poly- or α-Si layer is deposited and structured over the opened insulation layer (117) and is used as an emitter doping agent source and contact layer, a doping profile is introduced into the cap layer (116), which doping profile is weakly doped on the base side and more highly doped on the emitter side, **characterised in that** the said doping profile is introduced into the cap layer (116) before the diffusion stage from the emitter doping agent source, so that in the overlapping region, the area between the edge of the emitter window and the outer limit of the structured poly- or α Si-layer, the cap layer contains said doping profile.

2. Method according to claim 1, **characterised in that** the base-side weaker doping agent concentration of the cap layer (116) does not exceed values of 5^{*}10¹⁶ cm⁻³.

3. Method according to claim 1 or 2, **characterised in that** the base-side weaker doping agent concentration of the cap layer (116) has a layer thickness of between 20 nm and 70 nm.

4. Method according to one or more of the preceding claims, **characterised in that** the emitter-side greater doping agent concentration of the cap layer (116) does not exceed values of 5^{*}10¹⁸ cm⁻³, when the doping agent has the same conductivity type as the base layer (115).

5. Method according to one or more of the preceding claims, **characterised in that** the cap doping profile is introduced by implantation.

6. Method according to one or more of the preceding claims, **characterised in that** the cap doping profile is introduced in situ during the epitaxy process.

7. Method according to one or more of the preceding claims, **characterised in that** the cap doping profile is produced by diffusion out from the insulation layer (117) which has been highly enriched by doping agent.

8. Bipolar transistor in which structured regions, consisting of a collector region (112) and insulation regions (113) surrounding the latter are produced on a monocrystal substrate layer (111), over the collector region (112) a base layer (115), whereby a buffer layer (114) can be placed in between, and by means of epitaxy a cap layer (116) is produced, an insulation layer (117) is deposited over the cap layer (116) and said insulation layer is opened in an area of the effective emitter zone, a poly- or an α-Si layer is deposited and structured over the opened insulation layer (117) and is used as an emitter-doping agent source and contact layer, **characterised in that** in an overlapping region (17), the area between the edge of the emitter window and the outer limit of the structured poly- or α-silicon layer (15), the cap layer (13/116) contains a doping profile, which is doped weakly on the base side and more highly on the emitter side.

9. Bipolar transistor according to claim 8 , **characterised in that** the base-side weaker doping agent concentration of the cap layer (13/116) does not exceed values of 5^{*}10¹⁶ cm⁻³

10. Bipolar transmitter according to one or more of claims 8 to 9, **characterised in that** the base-side weaker doping agent concentration of the cap layer (13/116) has a layer thickness of between 20 nm and 70 nm.

11. Bipolar transistor according to one or more of claims 8 to 10, **characterised in that** the emitter-side greater doping agent concentration of the cap layer (13/116) does not exceed values of 5^{*}10¹⁸ cm⁻³ when the doping agent has the same conductivity type as the base layer (12,115).

## Revendications

1. Procédé pour la fabrication d'un transistor bipolaire, selon lequel, sur une couche formant substrat monocristallin (111), on forme des régions structurées, constituées par une région de collecteur (112), ainsi que des régions isolantes (113) entourant cette région, et une couche de base (115) au-dessus de la région de collecteur (112), une couche tampon intercalaire (114), selon lequel on peut déposer une couche tampon intercalaire (114) et fabriquer par épitaxie une couche formant chapeau (116), on dépose une couche isolante (117) au-dessus de la couche formant chapeau (116) et on ouvre cette couche isolante au niveau de la région active d'émetteur, on dépose une couche de poly-Si ou α-Si au-dessus de la couche isolante ouverte (117), on la structure et on l'utilise en tant que couche de dopant d'émetteur et couche de contact, et on introduit un profil de dopage dans la couche formant chapeau (116) qui est faiblement dopée côté base et plus fortement dopée côté émetteur, **caractérisé en ce que** ledit profil de dopage est inséré dans la couche formant chapeau (116) avant l'étape de diffusion à partir de la source du dopant d'émetteur, de sorte que dans la zone de chevauchement, la zone entre le bord de la fenêtre d'émetteur et la limite extérieure de la couche de poly-Si ou de α-Si est structurée, la couche formant chapeau contient ledit profil de dopage.

2. Procédé selon la revendication 1, **caractérisé en ce que** la concentration de dopant plus faible côté base de la couche formant chapeau (116) ne dépasse pas des valeurs de 5.10¹⁶ cm⁻³.

3. Procédé selon la revendication 1 ou 2, **caractérisé en ce que** la concentration de dopant, plus faible côté base, de la couche formant chapeau (116) possède une épaisseur de couche comprise entre environ 20 nm et 70 nm.

4. Procédé selon une ou plusieurs des revendications précédentes, **caractérisé en ce** la concentration de dopant, plus élevée côté émetteur de la couche formant chapeau (116) ne dépasse pas des valeurs de 5.10¹⁸ cm⁻³, lorsque le dopant possède le type de conductivité de la couche de base (115).

5. Procédé selon une ou plusieurs des revendications précédentes, **caractérisé en ce que** le profil de dopage du chapeau est inséré au moyen d'une implantation.

6. Procédé selon une ou plusieurs des revendications précédentes, **caractérisé en ce que** le profil de dopage du chapeau est inséré sur place pendant l'étape d'épitaxie.

7. Procédé selon une ou plusieurs des revendications précédentes, **caractérisé en ce que** le profil de dopage du chapeau est produit par diffusion à partir de la couche isolante (117) fortement enrichie en dopant.

8. Transistor bipolaire, auquel des régions structurées constituées par une région de collecteur (112) ainsi que des régions isolantes (113) entourant cette région sont produites sur une couche en substrat monocristallin (111), une couche de base (115) est disposée sur la couche de collecteur (112), une couche tampon (114) pouvant être intercalée et une couche formant chapeau (116) pouvant être réalisée par épitaxie, une couche isolante (117) est disposée sur la couche formant chapeau (116) et cette couche est ouverte dans la zone de la région active d'émetteur, et une couche de poly-Si ou de α-Si est déposée au-dessus de la couche isolante ouverte (117), et est utilisée en tant que source de dopant d'émetteur et couche de contact, **caractérisé en ce que** dans la zone de chevauchement (17) la région entre le bord de la fenêtre d'émetteur et la limite extérieure de la couche structurée de polysilicium ou de α-silicium (15), la couche formant chapeau (13/116) contient un profil de dopage qui est faiblement dopé côté base et plus fortement dopé côté émetteur.

9. Transistor bipolaire selon la revendication 8, **caractérisé en ce que** la concentration de dopant plus faible côté base de la couche formant chapeau (13/116) ne dépasse pas des valeurs de 5.10¹⁶ cm⁻³.

10. Transistor bipolaire selon une ou plusieurs des revendications 8 à 9, **caractérisé en ce que** la concentration de dopant, plus faible côté base, de la couche formant chapeau (13/116) possède une épaisseur de couche comprise entre environ 20 nm et 70 nm.

11. Transistor bipolaire selon une ou plusieurs des revendications 8 à 10, **caractérisé en ce que** la concentration de dopant, supérieure côté émetteur, de la couche formant chapeau (13/116) ne dépasse pas des valeurs de 5.10¹⁸ cm⁻³, lorsque le dopant possède le type de conductivité de la couche de base (12, 115).
